# EUROPEAN PATENT APPLICATION

(11) **EP 4 365 951 A1**
(43) Date of publication of application: **08.05.2024**
(21) Application number: 22832408.3
(22) Date of filing: 10.02.2022
(51) Int. Cl.: H01L 27/146, H04N 25/70

(54) **IMAGE CAPTURE ELEMENT AND ELECTRONIC DEVICE**

(30) Priority: 30.06.2021 JP 2021108346
(71) Applicant: Sony Semiconductor Solutions Corporation, Atsugi-shi, Kanagawa 243-0014 (JP)
(72) Inventor: EBIKO Yoshiki, Atsugi-shi, Kanagawa 243-0014 (JP)
(74) Representative: Müller Hoffmann & Partner
(86) International application number: PCT/JP2022/005253
(87) International publication number: WO 2023/276240

(57) **Abstract**

The present technology relates to an imaging element and an electronic device that enable provision of an imaging element that enables pixels to be reduced in size without increasing a thickness of an Si layer and efficiently absorbs light with a long wavelength.

Photoelectric conversion regions and a recessed portion region including a plurality of recessed portions provided on a light-receiving surface side of the photoelectric conversion regions are included, and the recessed portions are provided in a shape with no intersecting parts in a plan view. The recessed portions are configured of first recessed portions formed in a linear shape in a first direction and second recessed portions formed into a linear shape in a second direction, the first recessed portions and the second recessed portions are provided in a shape with no intersecting parts. The present technology can be applied to an imaging element that receives light with a long wavelength, for example.

## Description

### [Technical Field]

The present technique relates to an imaging element and an electronic device, for example, an imaging element and an electronic device with enhanced light receiving sensitivity with respect to light of a longer wavelength such as an infrared band, for example.

### [Background Art]

As imaging elements, charge coupled devices (CCDs) and complementary metal-oxide semiconductors (CMOS) image sensors have been used. For light absorption layers performing photoelectrical conversion in these imaging elements, single crystal Si (silicon) has generally been used.

Silicon is an indirect transition-type semiconductor, the band gap thereof is 1.1 eV, and silicon thus has sensitivity with respect to visible wavelengths to a near-infrared wavelength of about 1.1 pm (micrometers). However, light absorption efficiency per unit thickness decreases as the wavelength increases due to wavelength dependency of a light absorption coefficient. However, in a case where it is attempted to realize an imaging element having high sensitivity with respect to light from a red color to an infrared band, increasing the thickness of the Si layer is known as an effective method.

On the other hand, size reduction and an increase in number of pixels of the imaging element have been desired, and the pixels have thus been further downsized.

An imaging device that is provided with an irregular structure on a light receiving surface-side interface of a photoelectric conversion region of each of pixels arranged in a two-dimensional manner and efficiently absorbs light with a long wavelength by diffracting light by the irregular structure has been proposed (see PTL 1, for example).

### [Citation List]

### [Patent Literature]

[PTL 1]
JP 2015-29054A

### [Summary]

### [Technical Problem]

There has been a desire to enable provision of an imaging element that enables pixels to be reduced in size without increasing the thickness of an Si layer and efficiently absorbs light with a long wavelength.

The present technology was made in view of such a circumstance, and an object thereof is to enable even light with a long wavelength to be efficiently absorbed.

### [Solution to Problem]

An imaging element according to an aspect of the present technology includes: photoelectric conversion regions; and a recessed portion region that has a plurality of recessed portions provided on a light receiving surface side of the photoelectric conversion regions, the recessed portions being provided in a shape with no intersecting parts in a plan view.

An electronic device according to an aspect of the present technology is an electronic device including: an imaging element including photoelectric conversion regions and a recessed portion region that has a plurality of recessed portions provided on a light-receiving surface side of the photoelectric conversion regions, the recessed portions being provided in a shape with no intersecting parts in a plan view; and a processing unit that processes a signal from the imaging element.

In the imaging element according to an aspect of the present technology, the photoelectric conversion regions and the recessed portion region that has the plurality of recessed portions provided on the light-receiving surface side of the photoelectric conversion regions are included, and the recessed portions are provided in a shape with no intersecting parts in a plan view.

The electronic device according to one aspect of the present technique is configured to include the imaging element.

Note that the electronic device may be an independent device or an internal block constituting a single device.

### [Brief Description of Drawings]

[Fig. 1]

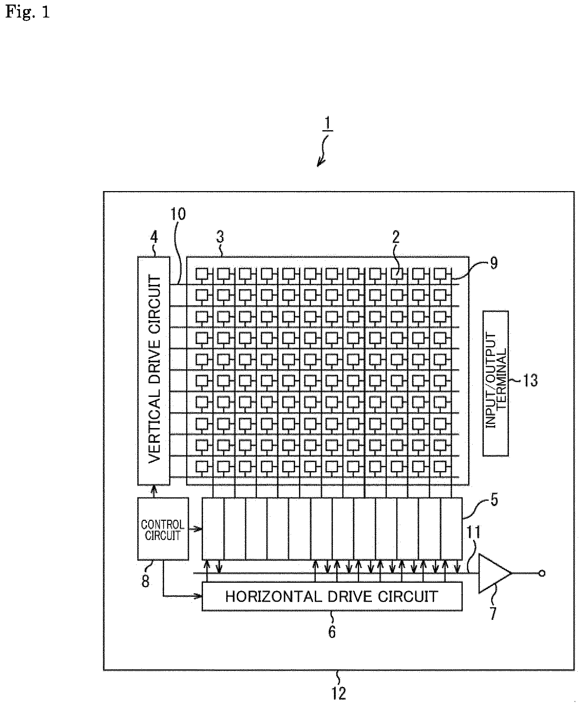

   Fig. 1 is a diagram illustrating a schematic configuration of an imaging device according to the present disclosure.
[Fig. 2]

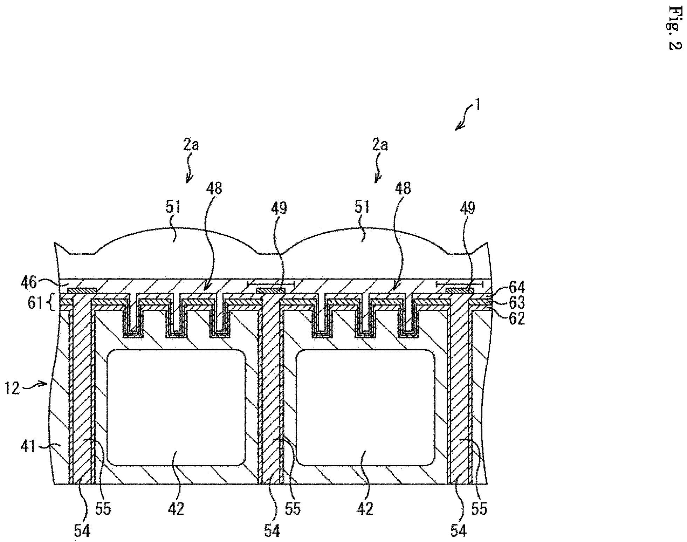

   Fig. 2 is a diagram illustrating an exemplary sectional configuration of a pixel according to first embodiment.
[Fig. 3]

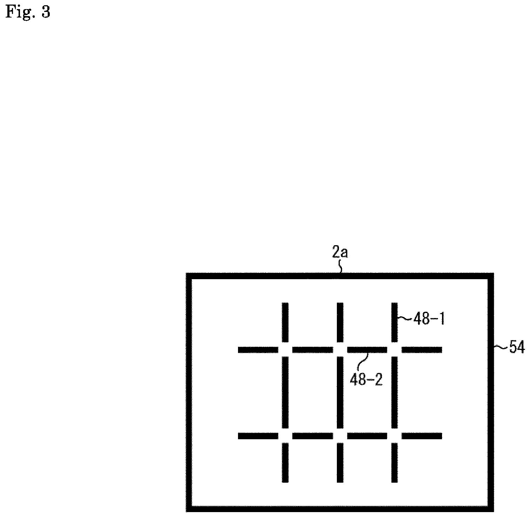

   Fig. 3 is a diagram illustrating an exemplary planar configuration of a pixel.
[Fig. 4]

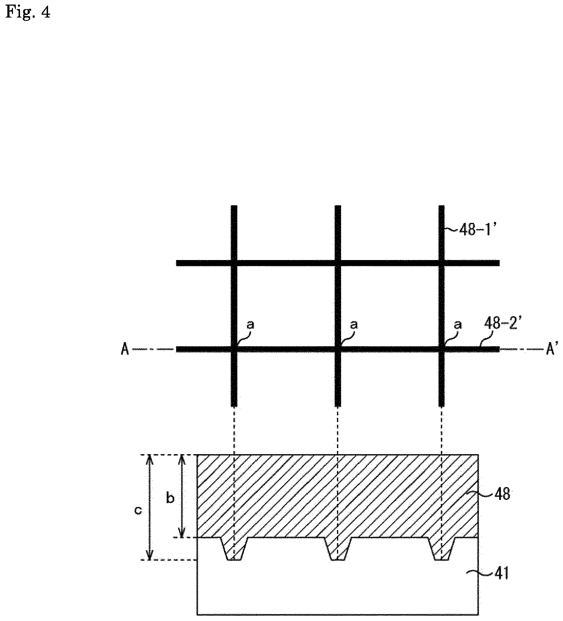

   Fig. 4 is a diagram for explaining a depth of a recessed portion.
[Fig. 5]

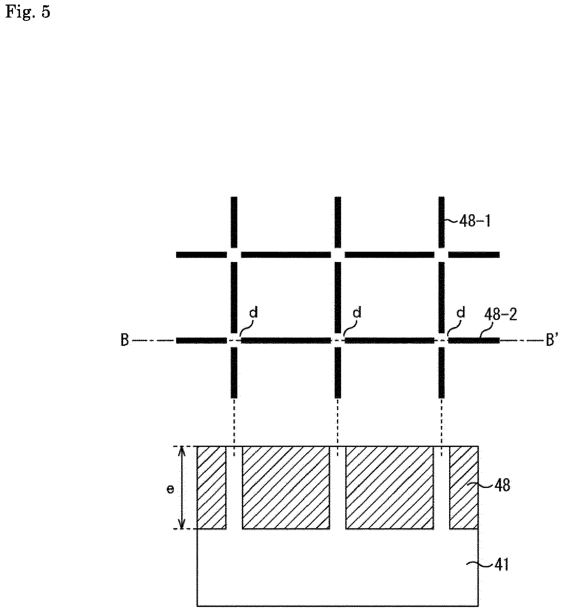

   Fig. 5 is a diagram for explaining the depth of the recessed portion.
[Fig. 6]

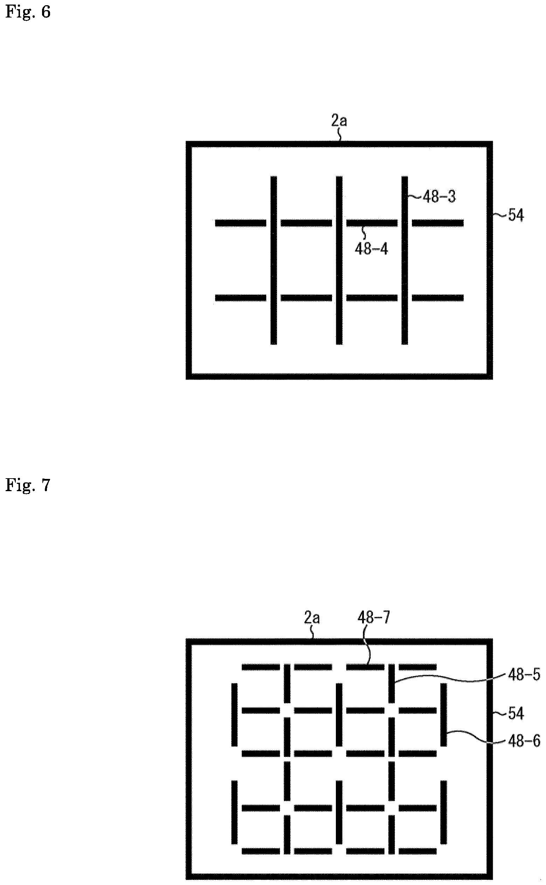

   Fig. 6 is a diagram illustrating another exemplary planar configuration of the pixel.
[Fig. 7]
   Fig. 7 is a diagram illustrating another exemplary planar configuration of the pixel.
[Fig. 8]

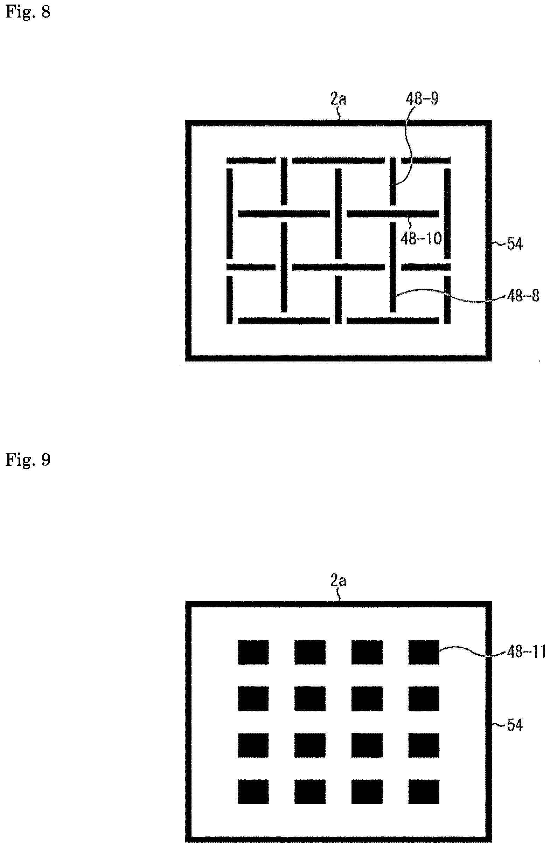

   Fig. 8 is a diagram illustrating another exemplary planar configuration of the pixel.
[Fig. 9]
   Fig. 9 is a diagram illustrating another exemplary planar configuration of the pixel.
[Fig. 10]

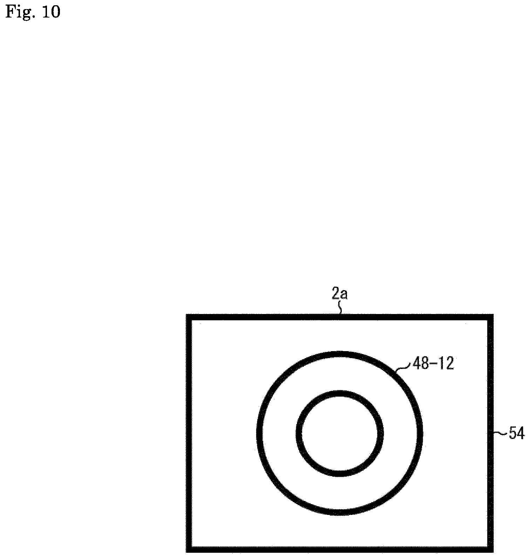

   Fig. 10 is a diagram illustrating another exemplary planar configuration of the pixel.
[Fig. 11]

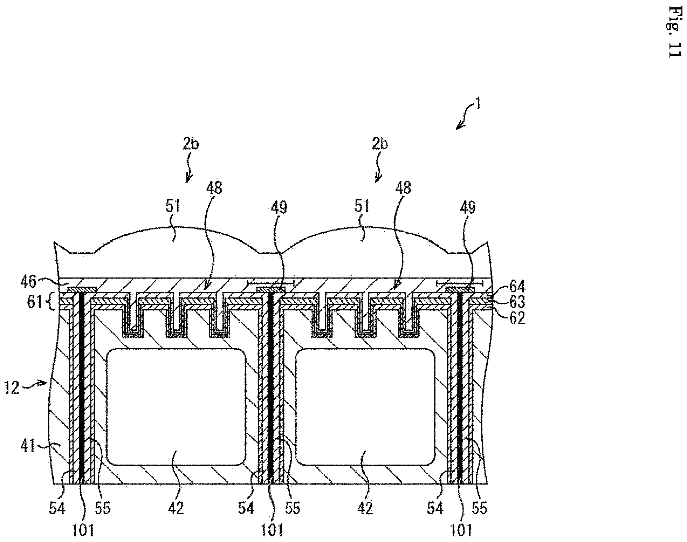

   Fig. 11 is a diagram illustrating a sectional configuration of a pixel according to a second embodiment.
[Fig. 12]

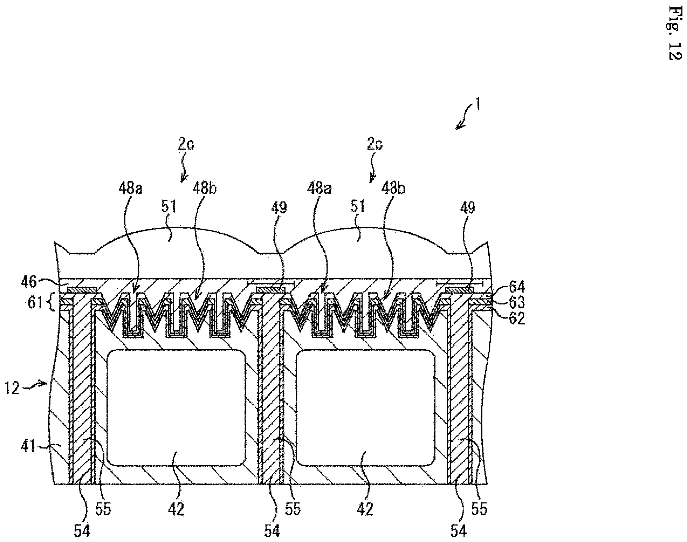

   Fig. 12 is a diagram illustrating a sectional configuration of a pixel according to a third embodiment.
[Fig. 13]

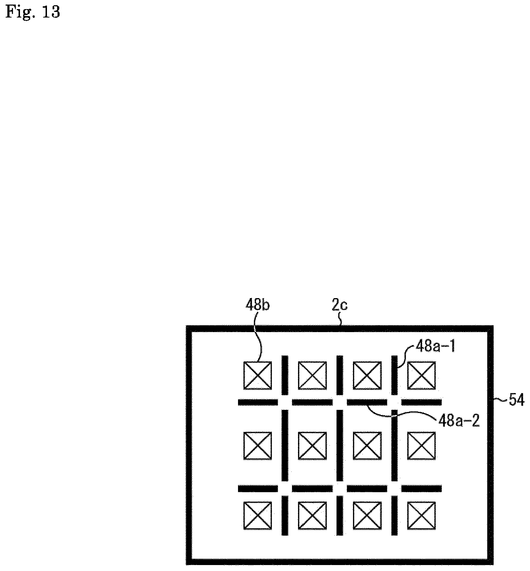

   Fig. 13 is a diagram illustrating another exemplary planar configuration of the pixel.
[Fig. 14]

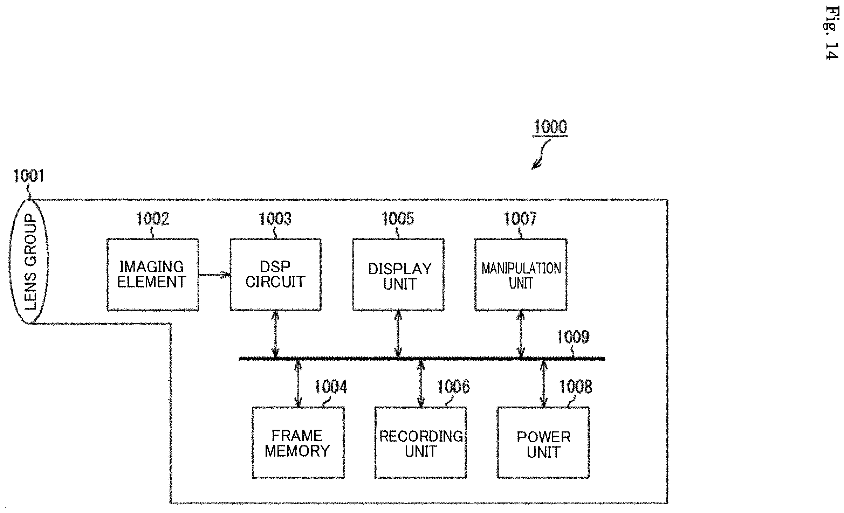

   Fig. 14 is a block diagram illustrating an exemplary configuration of an electronic device.
[Fig. 15]

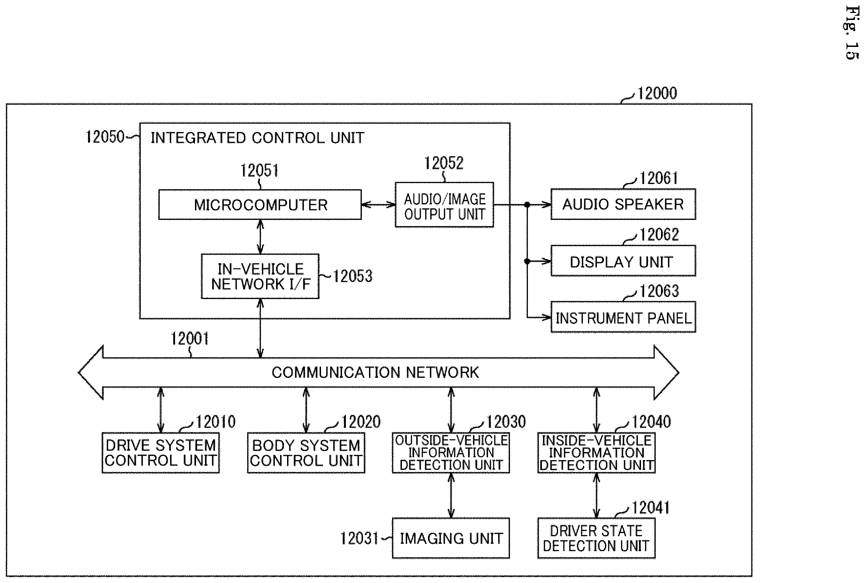

   Fig. 15 is a block diagram illustrating an example of a schematic configuration of a vehicle control system.
[Fig. 16]

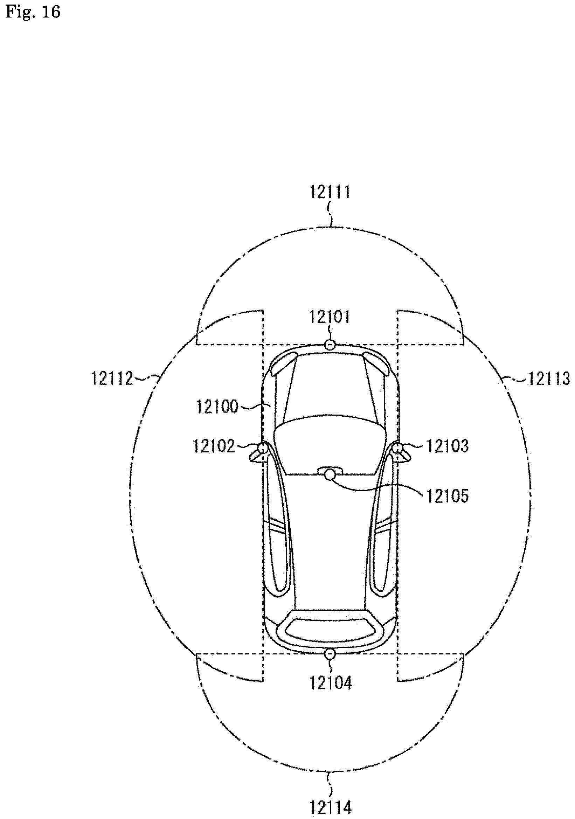

   Fig. 16 is an explanatory diagram illustrating an example of installation positions of an outside-vehicle information detection unit and an imaging unit.

### [Description of Embodiments]

Hereinafter, modes for carrying out the present technique (hereinafter, referred to as "embodiments") will be described.

### <Exemplary schematic configuration of imaging device>

Fig. 1 is a diagram illustrating a schematic configuration of an imaging device according to the present disclosure.

An imaging device 1 in Fig. 1 is configured to have a pixel array unit 3 including pixels 2 aligned in a two-dimensional array form on a semiconductor substrate 12 using silicon (Si), for example, as a semiconductor and a peripheral circuit unit in the surroundings thereof. The peripheral circuit unit includes a vertical drive circuit 4, column signal processing circuits 5, a horizontal drive circuit 6, an output circuit 7, a control circuit 8, and the like.

Each pixel 2 includes a photodiode as a photoelectric conversion element and a plurality of pixel transistors. The plurality of pixel transistors are configured using, for example, four MOS transistors, namely a transfer transistor, a selection transistor, a reset transistor, and an amplification transistor.

Also, the pixel 2 can have a shared pixel structure. The pixel shared structure is configured of a plurality of photodiodes, a plurality of transfer transistors, one floating diffusion (floating diffusion region) to be shared, and each one other pixel transistor to be shared. In other words, the shared pixel is configured such that the photodiodes and the transfer transistors configuring a plurality of unit pixels share each one other pixel transistor.

The control circuit 8 receives input clocks and data for providing an instruction regarding an operation mode and the like and outputs data such as internal information of the imaging device 1. In other words, in response to a vertical synchronizing signal, a horizontal synchronizing signal, and a master clock signal, the control circuit 8 generates clock signals or control signals to be used as a reference for operation by the vertical drive circuit 4, the column signal processing circuit 5, the horizontal drive circuit 6, and other elements. The control circuit 8 outputs the generated clock signals or control signals to the vertical drive circuit 4, the column signal processing circuits 5, the horizontal drive circuit 6 and other elements.

The vertical drive circuit 4 is constituted of, for example, a shift register, selects a pixel drive wiring 10, supplies a pulse for driving pixels 2 to the selected pixel drive wiring 10, and drives the pixels 2 in units of rows. In other words, the vertical drive circuit 4 selectively scans pixels 2 in the pixel array unit 3 on a row-basis in the vertical direction sequentially and supplies the column signal processing circuits 5 through a vertical signal line 9 with a pixel signal based on signal charge generated according to the amount of received light in the photoelectric conversion units of the pixels 2.

One column signal processing circuit 5 is arranged for each column of the pixels 2 and performs signal processing such as noise cancellation on a signal output from the pixels 2 corresponding to one row for each pixel column. For example, the column signal processing circuits 5 perform signal processing such as correlated double sampling (CDS) for canceling out fixed pattern noise unique to the pixels and AD conversion.

The horizontal drive circuit 6 is constituted by, for example, shift registers, and sequentially outputs a horizontal scanning pulse and thus selects each of the column signal processing circuits 5 in order, and outputs a pixel signal from each of the column signal processing circuits 5 to the horizontal signal line 11.

The output circuit 7 performs signal processing on signals sequentially supplied through the horizontal signal line 11 from each of the column signal processing circuits 5 and outputs the pixel signals. For example, the output circuit 7 may perform only buffering in some cases or may perform black level adjustment, column variation compensation, and various kinds of digital signal processing in other cases. Input/output terminals 13 exchange signals with the outside.

The imaging device 1 having the above configuration is a CMOS image sensor called a column AD type sensor, in which one column signal processing circuit 5 that performs CDS processing and AD conversion processing is arranged for each pixel column.

Also, the imaging device 1 is a back-illuminated MOS-type imaging device in which light is incident from a rear surface side, opposite to a front surface side on which the pixel transistors are formed, of the semiconductor substrate 12.

### <First embodiment>

Fig. 2 is a diagram illustrating an exemplary sectional configuration of a pixel 2a according to a first embodiment.

The imaging device 1 includes the semiconductor substrate 12 and a multilayer wiring layer and a support substrate (both of which are not illustrated) formed on the front surface side thereof.

The semiconductor substrate 12 is configured of silicon (Si), for example. In the semiconductor substrate 12, photodiodes PD (photoelectric conversion regions) are formed in units of pixels by N-type (second conductivity type) semiconductor regions 42 being formed in P-type (first conductivity type) semiconductor regions 41 for each pixel 2a, for example. The P-type semiconductor regions 41 provided on both the front and rear surfaces of the semiconductor substrate 12 also serve as hole charge accumulation regions for inhibiting a dark current.

As illustrated in Fig. 2, the imaging device 1 is configured by an anti-reflection film 61, a transparent insulating film 46, and an on-chip lens 51 being laminated on the semiconductor substrate 12 on which the N-type semiconductor region 42 configuring the photodiode PD is formed for each pixel 2a.

The anti-reflection film 61 that prevents reflection of incident light is formed by a recessed portion region 48 where a fine irregular structure is formed, on an interface (light-receiving surface-side interface) of the P-type semiconductor regions 41 on the upper side of the N-type semiconductor regions 42 serving as charge accumulation regions.

The anti-reflection film 61 has a laminated structure in which a fixed charge film and an oxide film are laminated, for example, and it is possible to use a high-dielectric-constant (High-k) thin insulating film based on an atomic layer deposition (ALD) method, for example. Specifically, it is possible to use hafnium oxide (HfO2), aluminum oxide (Al2O3), titanium oxide (TiO2), strontium titan oxide (STO), or the like. In the example in Fig. 2, the anti-reflection film 61 is configured by a hafnium oxide film 62, an aluminum oxide film 63, and a silicon oxide film 64 being laminated.

Furthermore, light shielding films 49 are formed between the pixels 2a with the light shielding films 49 laminated on the anti-reflection film 61. For the light shielding films 49, single-layer metal films of titanium (Ti), titanium nitride (TiN), tungsten (W), aluminum (Al), tungsten nitride (WN), or the like are used. Alternatively, a laminated film of such metal (for example, a laminated film of titanium and tungsten, a laminated film of titanium nitride and tungsten, or the like) may be used as the light shielding films 49.

The transparent insulating film 46 is formed on the entire surface of the P-type semiconductor regions 41 on the rear surface side (light incident surface side). The transparent insulating film 46 is a material that allows light to be transmitted therethrough, has an insulating property, and has a refractive index nl that is smaller than a refractive index n2 of the semiconductor regions 41 and 42 (n1 < n2). As a material of the transparent insulating film 46, it is possible to use silicon oxide (SiO2), silicon nitride (SiN), silicon oxynitride (SiON), hafnium oxide (HfO2), aluminum oxide (Al2O3), zirconium oxide (Zr02), tantalum oxide (Ta2O5), titanium oxide (TiO2), lanthanum oxide (La2O3), praseodymium oxide (Pr2O3), cerium oxide (CeO2), neodim oxide (Nd2O3), promethium oxide (Pm2O3), samarium oxide (Sm2O3), europium oxide (Eu2O3), gadolinium oxide (Gd2O3), terbium oxide (Tb2O3), dysprosium oxide (Dy2O3), holmium oxide (Ho2O3), thulium oxide (Tm2O3), ytterbium oxide (Yb2O3), lutetium oxide (Lu2O3), yttrium oxide (Y2O3), a resin, or the like alone or in combination.

A color filter layer may be formed on the upper side of the transparent insulating film 46 including the light shielding films 49. For example, a configuration in which a color filter layer of a red color (red), a green color (green), or a blue color (blue) may be formed for each pixel may be adopted.

The on-chip lens 51 is formed on the transparent insulating film 46 for each pixel 2a. The on-chip lens 51 is formed of, for example, a resin material such as a styrene resin, an acrylic resin, a styrene-acrylic copolymer resin, or a siloxane resin. Incident light is collected by the on-chip lens 51, and the collected light is efficiently incident on the photodiodes PD.

In the pixels 2a illustrated in Fig. 2, inter-pixel separating portions 54 for separating the pixels 2a are formed on the semiconductor substrate 12. The inter-pixel separating portions 54 are formed by forming trenches penetrating through the semiconductor substrate 12 between the N-type semiconductor regions 42 constituting the photodiodes PD, forming aluminum oxide films 63 on the inner surfaces of the trenches, and further filling in the trenches with insulators 55 when the silicon oxide film 64 is formed.

Note that parts of the silicon oxide film 64 with which the inter-pixel separating portions 54 are filled can be configured to be filled with polysilicon. Fig. 2 illustrates a case where the silicon oxide film 64 is formed to be integrated with the insulators 55.

The adjacent pixels 2a are completely electrically isolated by the insulators 55 filling in the trenches by configuring such inter-pixel separating portions 54. It is thus possible to prevent electrical charge generated inside of the semiconductor substrate 12 from leaking to the adjacent pixels 2a.

The inter-pixel separating portions 54 (the trenches constituting the inter-pixel separating portions 54) may be configured to penetrate through the semiconductor substrate 12 or may be configured not to penetrate therethrough.

The recessed portions formed in the recessed portion region 48 (hereinafter, in a case where one recessed portion from among the plurality of recessed portions formed in the recessed portion region 48 is represented, it will be described as a recessed portion 48) is formed into a quadrangular shape as illustrated in Fig. 2 in a sectional view. The recessed portion 48 has a depth before reaching the N-type semiconductor region 42 and is formed inside of the P-type semiconductor region 41.

The recessed portion 48 is an interface between the anti-reflection film 61 and the transparent insulating film 46, and has a shape having a recess in the depth direction in a case where the surface on which the light shielding film 49 is formed is employed as a reference, and will thus be described as a recessed portion. It is also possible to state that a projecting portion 48 formed into a projecting shape is formed in the recessed portion region 48 by the reference surface in a case where the upper surface of the N-type semiconductor region 42 is employed as a reference surface, for example. Here, the portion will be described as a recessed portion on the assumption that the portion is formed into a recessed shape in the depth direction from the reference surface with the surface on which the light shielding film 49 is formed defined as a reference surface.

It is possible to earn the optical path length of light incident on the pixel 2a by providing the recessed portion 48. The light incident on the pixel 2a is incident on the N-type semiconductor region 42 (photodiode) while repeating reflection, that is, the light hits and is reflected by a side surface of the recessed portion 48 and then hits and is reflected by a side surface of the recessed portion 48 at the opposing position. Since the optical path length increases by the reflection being repeated, it is possible to achieve a configuration capable of efficiently absorb even light with a long wavelength such as near-infrared light, for example.

Fig. 3 is a plan view of the pixel 2a and illustrates the shape of the recessed portion 48. In the following description, the up-down direction in the drawing will be described as a vertical direction, and left-right direction in the drawing will be described as a horizontal direction. Note that it is possible to apply the present technology even to a case where the vertical direction is read as the horizontal direction instead and the horizontal direction is read as the vertical direction instead in the following description.

The recessed portion 48 is configured of projecting portions 48-1 in the vertical direction and recessed portions 48-2 in the horizontal direction formed in a state where there is no mutually intersecting part. Although two recessed portions 48-1 and two recessed portions 48-2 form a quadrangular shape, for example, no recessed portions 48 are formed at parts corresponding to vertexes of the quadrangular shape.

In the example illustrated in Fig. 3, although the length of the recessed portion 48-1 formed in the vertical direction and corresponding to each side of the quadrangular shape constituted of the recessed portion 48 formed at the center is formed to be longer than the length of the recessed portion 48-2 formed in the horizontal direction, the quadrangular shape constituted of the recessed portion 48 formed at the center has a rectangular shape, the quadrangular shape may be a square shape with the length of the recessed portion 48-1 being the same as the length of the recess 48-2.

The recessed portions 48-1 and the recessed portions 48-2 on the side of the inter-pixel separating portion 54 of the pixel 2a are formed to have lengths to positions at which they do not come into contact with the inter-pixel separating portion 54.

The line width of the recessed portions 48-1 and the recessed portions 48-2 are formed to be a uniform line width. The recessed portions 48-1 formed into a linear shape have longer sides and shorter sides, and the shorter side is defined as the line width. The same applies to the recessed portions 48-2, and the shorter side is defined as the line width. The following description will be continued on the assumption that the shorter length of the recessed portion 48 in a plan view is defined as the line width and the recessed portion 48 is formed to have a uniform line width.

It is possible to obtain the same length of the recessed portion 48 in the depth direction by configuring the line width to be uniform with no intersecting parts included in the recessed portion 48 as illustrated in Fig. 3. This will be described with reference to Figs. 4 and 5.

Fig. 4 is a diagram for explaining the depth of the recessed portion 48 in a case where the recessed portion 48 is formed in a state with intersecting parts. As illustrated in the upper diagram in Fig. 4, recessed portions 48-1' (this will be described with an apostrophe to distinguish this from the recessed portion 48-1) and recessed portions 48-2' intersect each other at intersecting parts, for example, the parts represented as intersections a in Fig. 4.

The lower diagram in Fig. 4 is a diagram illustrating an exemplary sectional configuration of the recessed portions 48-2' along the line segment A-A' in the upper diagram of Fig. 4. The depth at the parts other than the intersections a of the recessed portions 48-2' will be denoted as depth b, and the depth at the parts corresponding to the intersections a will be denoted as the depth c. The depth c of the recessed portions 48-2' at the intersections a is deeper than the depth b of the recessed portions 48-2' other than the intersections a. In a case where the recessed portions 48-2' are formed by forming trenches through dry working, the depth at the parts where the trenches intersect each other is deeper than the other parts.

If the depths of the recessed portion 48 differs in this manner, the diffraction effect of silicon may be reduced, the dark current may increase, and it is thus preferable that the depths of the recessed portion 48 be uniform.

In a case where the recessed portion 48 is formed with no intersections as described above with reference to Fig. 3, it is possible to obtain the same depth for the recessed portion 48 as illustrated in Fig. 5. Referring to the upper diagram of Fig. 5, intersections in a case where the recessed portions 48-1 and the recessed portions 48-2 have intersecting parts will be defined as intersections d. Neither the recessed portions 48-1 nor the recessed portions 48-2 are formed at the intersections d.

The lower diagram of Fig. 5 is a diagram illustrating an exemplary sectional configuration of the recessed portions 48-2 along the line segment B-B' in the upper diagram of Fig. 5. The depth of the parts of the recessed portions 48-2 other than the intersections d will be defined as a depth e. Since no recessed portions 48-2 are formed at the parts corresponding to the intersections d, no recessed portions 48-2 are formed in a sectional view as well. On the other hand, the recessed portions 48-2 are formed at a depth e at parts other than the intersections d. In this manner, the recessed portions 48-2 are formed to have a uniform depth. Although not illustrated in the drawing, the recessed portions 48-1 are also formed to have the depth e.

It is possible to obtain the same depth of the recessed portion 48 by forming the recessed portion 48 in a shape with no intersecting parts in a plan view in this manner. It is possible to prevent the recessed portion 48 from being formed with non-uniform depths, for example, to prevent a part thereof from being formed to be deeper and to form it with a uniform depth even in a case where the recessed portion 48 is formed by forming each trench through dry working.

It is possible to prevent reduction of the silicon diffraction effect and an increase in dark current and to facilitate solution of Qs (saturated charge amount) and transfer design trade-off, by obtaining a constant depth of the recessed portion 48 (the depth of the trench).

Note that the uniform depth of the recessed portion 48 includes a range with an error of less than 10%. In a case where the predetermined depth e of the recessed portion 48 is defined as 1, for example, the depth of the recessed portion 48 falling within a depth e range of 0.9 to 1.1 is considered to be uniform. The error is an error that may be generated at the time of dry etching working of the recessed portion 48, and variations in depth of the recessed portion 48 falls less than 10% according to the pixel 2 to which the present technology is applied.

Referring to Fig. 3 again, the recessed portion 48 formed in the pixel 2a is formed with no intersecting parts. The recessed portion 48 is configured not to have parts intersecting the inter-pixel separating portion 54 as well, that is, the recessed portion 48 is configured not to have any contact parts. In a case where the inter-pixel separating portion 54 is formed by a trench, the inter-pixel separating portion 54 and the recessed portion 48 are formed in a shape with no intersection (contact) between the trench of the inter-pixel separating portion 54 and the trench of the recessed portion 48.

### <Other exemplary configurations of recessed portion>

Other shapes of the recessed portion 48 in a plan view will be described. Other shapes of the recessed portion 48 are also common in that the shapes do not have any intersecting parts.

Fig. 6 is a diagram illustrating another shape of the recessed portion 48 in a plan view. The recessed portion 48 illustrated in Fig. 6 is configured of recessed portions 48-3 formed in a linear shape in the vertical direction and recessed portions 48-4 formed in the horizontal direction within the pixel 2a in a plan view.

One recessed portion 48-3 is formed by one line from the upper side to the lower side of the inter-pixel separating portion 54 surrounding the pixel 2a. Although Fig. 6 illustrates an example in which three recessed portions 48-3 are formed in the pixel 2a, three or more recessed portions 48-3 may be formed. The recessed portions 48-3 are not in contact with the inter-pixel separating portion 54.

The recessed portions 48-4 are formed in the horizontal direction between the recessed portions 48-3 and in the horizontal direction between the recessed portions 48-3 and the inter-pixel separating portion 54. Although the example illustrated in Fig. 6 is an example in which the recessed portions 48-4 are formed in two rows, the recessed portions 48-4 may be formed in two or more rows.

The recessed portions 48-3 and the inter-pixel separating portion 54 are formed not to come into contact with each other. The shape of the recessed portion 48 illustrated in Fig. 6 is an example, and appropriate modifications may be made, for example, no recessed portions 48-4 are formed between the recessed portions 48-3 and the inter-pixel separating portion 54.

Fig. 7 is a diagram illustrating another shape of the recessed portion 48 in a plan view. The recessed portion 48 illustrated in Fig. 7 is configured of recessed portions 48-5 and 48-6 formed in a linear shape in the vertical direction and recessed portions 48-7 formed in the horizontal direction inside of the pixel 2a in a plan view.

In the vertical direction, the recessed portions 48-5 and the recessed portions 48-6 having a length that is about double the length of the recessed portions 48-5 are alternately disposed. The recessed portions 48-7 in the horizontal direction are formed between the recessed portions 48-5 and the recessed portions 48-6.

The recessed portion 48 is formed in a state where there are no parts at which the recessed portions 48-5, the recessed portions 48-6, and the recessed portions 48-7 overlap each other in the example illustrated in Fig. 7 as well. As in the example illustrated in Fig. 7, the shape in which the recessed portions 48-5 and the recessed portions 48-6 with different lengths are present together may also be adopted.

Fig. 8 is a diagram illustrating another shape of the recessed portion 48 in a plan view. The recessed portion 48 illustrated in Fig. 8 is configured of recessed portions 48-8 and recessed portions 48-9 formed in a linear shape in the vertical direction and the recessed portions 48-10 formed in the horizontal direction in the pixel 2a in a plan view.

In the vertical direction, the recessed portions 48-8 and the recessed portions 48-9 having a shorter length than the recessed portions 48-8 are alternately disposed. The recessed portions 48-10 in the horizontal direction are formed between the recessed portions 48-8 and the recessed portions 48-10 in the vertical direction and between the recessed portions 48-8 in the horizontal direction.

The recessed portions 48-10 are formed not to come into contact with each of the recessed portions 48-8 and the recessed portions 48-9. The recessed portions 48-10 formed near the center of the pixel 2a and the recessed portions 48-10 formed in the pixel 2a on the side of the inter-pixel separating portion 54 are formed to have different lengths.

The recessed portion 48 is formed in a state where there are no parts at which the recessed portions 48-8, the recessed portions 48-9, and the recessed portions 48-7 overlap each other in the example illustrated in Fig. 8 as well.

Fig. 9 is a diagram illustrating another shape of the recessed portion 48 in a plan view. Recessed portions 48-11 are formed in a quadrangular shape in the pixel 2a. In the example illustrated in Fig. 9, each recessed portion 48-11 is formed as a dot, and each dot is formed at such a position and with such a size that they do not come into contact with each other.

Fig. 10 is a diagram illustrating another shape of the recessed portion 48 in a plan view. Circular recessed portions 48-12 are formed in the pixel 2a. Although the example illustrated in Fig. 10 is an example in which two recessed portions 48-12 that are concentric circles are formed, one circular recessed portion 48-12 may be formed, or three or more circular recessed portions 48-12 may be formed.

The recessed portions 48-12 are formed with such a size and positional relationship that the recessed portions 48-12 do not come into contact with each other, and with such a size and positional relationship that the recessed portions 48-12 and the inter-pixel separating portion 54 also do not come into contact with each other, in the circular recessed portions 48-12 as well.

### <Example of configuration of pixel in second embodiment>

Fig. 11 is a diagram showing an exemplary configuration of a pixel 2b according to a second embodiment. The same parts as those in the pixel 2a according to the first embodiment illustrated in Fig. 2 will be denoted by the same reference signs, and description thereof will be appropriately omitted.

The pixel 2b according to the second embodiment illustrated in Fig. 11 is different from the pixel 2a according to the first embodiment illustrated in Fig. 2 in that a metal film 101 is formed in the inter-pixel separating portion 54 of the pixel 2a, and the pixel 2b is configured similarly to the pixel 2a in the other points.

The metal film 101 is a film formed by metal (tungsten, for example) that reflects light. The metal film 101 has a function of preventing light from leaking to adjacent pixels 2b and returning light to the inside of the photodiode. It is possible to electrically and optically isolate the pixel 2b from adjacent pixels 2b in a more reliable manner by providing the metal film 101.

The metal film 101 may be configured through integral formation (continuous shape) with the light shielding film 49. Materials of the metal film 101 and the light shielding film 49 may be the same material. For example, it is possible to form the metal film 101 and the light shielding film 49 as a single-layer metal film of titanium (Ti), titanium nitride (TiN), tungsten (W), aluminum (Al), tungsten nitride (WN), or the like. Alternatively, the metal film 101 and the light shielding film 49 may be configured by using a laminated film of such metal (for example, a laminated film of titanium and tungsten a laminated film of titanium nitride and tungsten, or the like).

The recessed portion 48 formed in the pixel 2b is formed in a shape with no intersecting parts as described above in the pixel 2b illustrated in Fig. 11 as well. As the shape of the recessed portion 48 in a plan view, it is possible to apply any of the shapes illustrated in Figs. 3 and 6 to 10.

It is possible to obtain the constant depth of the recessed portion 48 (the depth of the trench), to prevent reduction of the silicon diffraction effect and an increase in dark current, and to facilitate solution of Qs (saturated charge amount) and trade-off of the transfer design, even in the pixel 2b according to the second embodiment as well.

### <Exemplary configuration of pixel according to third embodiment>

Fig. 12 is a diagram illustrating an exemplary configuration of a pixel 2c according to a third embodiment. The same parts as those in the pixel 2a according to the first embodiment illustrated in Fig. 2 will be denoted by the same reference signs, and description thereof will be appropriately omitted.

The pixel 2c according to the third embodiment illustrated in Fig. 12 is different from the pixel 2a according to the first embodiment illustrated in Fig. 2 in that a recessed portion 48 with a different shape is included in the recessed portion region 48 of the pixel 2a, and the pixel 2c is configured similarly to the pixel 2a in the other points.

In the recessed portion region 48, recessed portions 48a with a quadrangular shape and recessed portions 48b with a triangular shape are alternately formed in a sectional view. Each recessed portion 48a corresponds to the recessed portion 48 of the pixel 2a according to the first embodiment and is formed in a shape with no intersecting parts in a plan view.

In the pixel 2c illustrated in Fig. 12, the recessed portions 48a with the quadrangular shape are formed to have a deeper depth than the recessed portions 48b with the triangular shape. A configuration in which the recessed portions 48a are formed to have a shallower depth than the recessed portions 48b may be adopted, or a configuration in which the recessed portions 48a and 48b have the same depth may be adopted.

The recessed portions 48a and the recessed portions 48b are formed by crystal anisotropic etching which is dry etching or wet etching. Both the recessed portions 48a and the recessed portions 48b may be formed by dry etching or wet etching, or one of them may be formed by dry etching while the other may be formed by wet etching.

For example, the recessed portion 48a can be formed by crystal anisotropic etching which is dry etching while the recessed portions 48b can be formed by crystal anisotropic etching which is wet etching.

In a case where the recessed portions 48b are formed by wet etching, there is a trend that the depth (corresponding to the height of the triangular shape) is shorter than the length (line width) of the parts corresponding to the bottom side of the recessed portions 48b with the triangular shape in a sectional view. A degree of freedom of the dry etching is higher in the depth direction as compared with the wet etching, and a deep trench can be formed by the dry etching.

In a case where the recessed portions 48a are formed to have a deeper depth than the recessed portions 48b as described above, it is possible to form the recessed portions 48 with different depths by forming the recessed portions 48a by dry etching and forming the recessed portions 48b by wet etching. In other words, it is possible to form the recessed portions 48 with different depths by applying different etching methods.

In a case where the recessed portions 48b are formed by wet etching, the recessed portions 48b are formed by crystal anisotropic wet etching using single-crystal silicon with a front orientation (100) of a silicon substrate and using an alkaline solution such as potassium hydroxide (KOH), for example. In a case of such formation, etching progresses such that the (111) plane appears on the opening-side wall.

As a result, a trench with a quadrangular planar shape and with a pyramid or similar three-dimensional shape is obtained. In other words, it is possible to form the recessed portions 48b with a triangular shape in a sectional view as illustrated in Fig. 12 and with a quadrangular shape in a plan view as will be described with reference to Fig. 13.

Fig. 13 is a plan view of the pixel 2c and is a diagram representing the shapes of the recessed portions 48a and the recessed portions 48b. Although the case where the recessed portions 48a are similar to the recessed portions 48 illustrated in Fig. 3 is illustrated, it is also possible to apply the shapes of the recessed portions 48 illustrated in Figs. 6 to 10. In the example illustrated in Fig. 13, the recessed portions 48a are configured of projecting portions 48a-1 in the vertical direction and recessed portions 48a-2 in the horizontal direction in a state where there are no mutually intersecting parts.

The recessed portions 48b are formed between the recessed portions 48a. Although the recessed portions 48b are formed in a triangular shape as illustrated in Fig. 12 in a sectional view, the recessed portions 48b are formed in a quadrangular shape as illustrated in Fig. 13 in a plan view. The recessed portions 48b are formed in four-sided pyramid shape which is a shape similar to a pyramid, for example. The recessed portions 48b with the four-sided pyramid shape and the recessed portions 48a with a rectangular parallelepiped shape are configured not to have any contact parts.

The recessed portions 48a and the recessed portions 48b are formed not to come into contact with the inter-pixel separating portion 54 as well.

Note that although the example in which one recessed portion 48b is formed between the recessed portions 48a in the pixel 2c illustrated in Figs. 12 and 13 has been illustrated, the pixel 2c can also be configured such that a plurality of recessed portions 48b are formed. Although the example in which one recessed portion 48b is formed in a region surrounded by the recessed portions 48a in the pixel 2c illustrated in Figs. 12 and 13 has been illustrated, it is also possible to configure the pixel 2c such that a plurality of recessed portions 48b, for example, 2 × 2, that is, a total of four recessed portions 48b are formed in each of the vertical direction and the horizontal direction.

Although the pixel 2c illustrated in Figs. 12 and 13 is in a mode where the first embodiment and the third embodiment are combined, a mode in which the second embodiment and the third embodiment are combined may be adopted. In a case of a combination with the second embodiment, the metal film 101 is provided in the inter-pixel separating portion 54.

Since the recessed portions 48a, the recessed portions 48b, the inter-pixel separating portion 54 are formed such that no contact is made between the recessed portions 48a, between the recessed portions 48b, between the recessed portions 48a and the recessed portions 48b, between the recessed portions 48a and the inter-pixel separating portion 54, and between the recessed portions 48b and the inter-pixel separating portion 54 in this manner, it is possible to obtain constant depths of the recessed portions 48a and the recessed portions 48b (the depth of the trench), to prevent reduction of the silicon diffraction effect and an increase in dark current, and to facilitate solution of Qs (saturated charge amount) and trade-off of a transfer design, similarly to the first and second embodiments.

It is possible to enhance the diffraction effect and to confine light inside of the Si layer by causing the recessed portions 48a and the recessed portions 48b with different shapes to be present together in the recessed portion region 48.

### <Examples of application to electronic device>

The present technology is not limited to an application to an imaging element. In other words, the present technology can be generally applied to electronic devices using imaging elements in image capturing portions (photoelectric conversion units) such as imaging devices such as a digital still camera and a video camera, a mobile terminal device having an imaging function, and a copy machine using an imaging element in an image reading unit. The imaging element may be in a mode in which it is formed as a one chip or may be in a mode in which it is formed as a module having an imaging function with an imaging unit and a signal processing unit or an optical unit collectively packaged therein.

Fig. 14 is a block diagram illustrating an exemplary configuration of an imaging device as an electronic device to which the present technology is applied.

An imaging element 1000 in Fig. 14 includes an optical unit 1001 formed of a lens group, an imaging element (an imaging device) 1002 in which the configuration of the imaging device 1 in Fig. 1 is adopted, and a digital signal processor (DSP) circuit 1003 which is a camera signal processing circuit. The imaging element 1000 includes a frame memory 1004, a display unit 1005, a recording unit 1006, a manipulation unit 1007, a power unit 1008. The DSP circuit 1003, the frame memory 1004, the display unit 1005, the recording unit 1006, the manipulation unit 1007, and the power unit 1008 are connected to each other via a bus line 1009.

The optical unit 1001 captures incident light (image light) from an object and forms an image on an imaging surface of the imaging element 1002. The imaging element 1002 converts an amount of incident light formed on the imaging surface by the optical unit 1001 into an electrical signal in units of pixels and outputs the electrical signal as a pixel signal. The imaging device 1 in Fig. 1 can be used as the imaging element 1002.

The display unit 1005 is configured as, for example, a thin display such as a liquid crystal display (LCD) or an organic electro luminescence (EL) display and displays a moving image or a still image captured by the imaging element 1002. The recording unit 1006 records a moving image or a still image captured by the imaging element 1002 in a recording medium such as a hard disk or a semiconductor memory.

The manipulation unit 1007 gives manipulation commands for various functions that the imaging element 1000 has in response to user's operations. The power unit 1008 appropriately supplies various types of power serving as operation power sources of the DSP circuit 1003, the frame memory 1004, the display unit 1005, the recording unit 1006, and the manipulation unit 1007 to supply targets.

### <Examples of application to moving body>

The technology of the present disclosure (the present technology) can be applied to various products. For example, the technique according to the present disclosure may be realized as a device mounted on any type of moving body such as an automobile, an electric automobile, a hybrid electric automobile, a motorcycle, a bicycle, a personal mobility device, an airplane, a drone, a ship, a robot, or the like.

Fig. 15 is a block diagram illustrating an exemplary schematic configuration of a vehicle control system which is an example of a moving body control system to which the technology according to the present disclosure can be applied.

The vehicle control system 12000 includes a plurality of electronic control units connected to each other via a communication network 12001. In the example illustrated in Fig. 15, the vehicle control system 12000 includes a drive system control unit 12010, a body system control unit 12020, an outside-vehicle information detection unit 12030, an inside-vehicle information detection unit 12040, and an integrated control unit 12050. As a functional configuration of the integrated control unit 12050, a microcomputer 12051, an audio/image output unit 12052, and an in-vehicle network I/F (interface) 12053 are illustrated.

The drive system control unit 12010 controls operations of devices related to a drive system of a vehicle according to various programs. For example, the drive system control unit 12010 functions as a control device for a driving force generation device for generating a driving force of the vehicle such as an internal combustion engine or a drive motor, a driving force transmission mechanism for transmitting the driving force to wheels, a steering mechanism for adjusting a steering angle of the vehicle, and a braking device for generating a braking force of a vehicle.

A body system control unit 12020 controls operations of various devices mounted in the vehicle body according to various programs. For example, the body system control unit 12020 functions as a control device of a keyless entry system, a smart key system, a power window device, or various lamps such as a head lamp, a back lamp, a brake lamp, a turn indicator, and a fog lamp. In this case, radio waves transmitted from a portable device that substitutes for a key or signals of various switches may be input to the body system control unit 12020. The body system control unit 12020 receives inputs of the radio waves or signals and controls a door lock device, a power window device, a lamp, and the like of the vehicle.

The outside-vehicle information detection unit 12030 detects external information of a vehicle on which the vehicle control system 12000 is mounted. For example, an imaging unit 12031 is connected to the outside-vehicle information detection unit 12030. The outside-vehicle information detection unit 12030 causes the imaging unit 12031 to capture an image outside of the vehicle and receives the captured image. The outside-vehicle information detection unit 12030 may perform object detection processing or distance detection processing for persons, cars, obstacles, signs, and letters on road surfaces on the basis of the received image.

The imaging unit 12031 is an optical sensor that receives light and outputs an electrical signal according to the amount of the received light. The imaging unit 12031 can also output the electrical signal as an image or can output the electrical signal as distance measurement information. In addition, the light received by the imaging unit 12031 may be visible light or may be invisible light such as infrared light.

The inside-vehicle information detection unit 12040 detects information on the inside of the vehicle. For example, a driver state detection unit 12041 that detects a driver's state is connected to the inside-vehicle information detection unit 12040. The driver state detection unit 12041 includes, for example, a camera that captures an image of a driver, and the inside-vehicle information detection unit 12040 may calculate a degree of fatigue or concentration of the driver or may determine whether or not the driver is dozing on the basis of detection information input from the driver state detection unit 12041.

The microcomputer 12051 can calculate a control target value of a driving force generation device, a steering mechanism, or a braking device on the basis of information inside and outside of the vehicle acquired by the outside-vehicle information detection unit 12030 or the inside-vehicle information detection unit 12040, and output a control command to the drive system control unit 12010. For example, the microcomputer 12051 can perform cooperative control for the purpose of realizing functions of an advanced driver assistance system (ADAS) including vehicle collision avoidance, impact mitigation, following traveling based on an inter-vehicle distance, driving with a vehicle speed maintained, vehicle collision warning, vehicle lane deviation warning, and the like.

Further, the microcomputer 12051 can perform cooperative control for the purpose of automated driving or the like in which autonomous travel is performed without depending on driver's operations, by controlling the driving force generating device, the steering mechanism, the braking device, and the like on the basis of information regarding the surroundings of the vehicle acquired by the outside-vehicle information detection unit 12030 or the inside-vehicle information detection unit 12040.

In addition, the microcomputer 12051 can output control commands to the body system control unit 12030 on the basis of the information outside of the vehicle acquired by the outside-vehicle information detection unit 12030. For example, the microcomputer 12051 can perform cooperative control for the purpose of antiglare such as switching from a high beam to a low beam by controlling a headlamp according to a position of a preceding vehicle or an oncoming vehicle detected by the outside-vehicle information detection unit 12030.

The audio/image output unit 12052 transmits an output signal of at least one of a sound or an image to an output device capable of visually or audibly notifying an occupant of the vehicle or the outside of the vehicle of information. In the example illustrated in Fig. 15, an audio speaker 12061, a display unit 12062, and an instrument panel 12063 are illustrated as output devices. The display unit 12062 may include, for example, at least one of an on-board display and a heads-up display.

Fig. 16 is a diagram illustrating an example of an installation position of the imaging unit 12031.

In Fig. 16, the imaging unit 12031 includes imaging units 12101, 12102, 12103, 12104, and 12105.

The imaging units 12101, 12102, 12103, 12104, and 12105 are provided, for example, at positions of a front nose, side mirrors, a rear bumper, a back door, an upper portion of a front windshield inside of the vehicle, and the like of the vehicle 12100. The imaging unit 12101 provided at the front nose and the imaging unit 12105 provided at the upper portion of the front windshield inside of the vehicle mainly acquire images in front of the vehicle 12100. The imaging units 12102 and 12103 provided at the side mirrors mainly acquire images on the lateral sides of the vehicle 12100. The imaging unit 12104 provided in the rear bumper or the back door mainly acquires images on the rear side of the vehicle 12100. The imaging unit 12105 provided at the upper portion of the windshield inside of the vehicle is mainly used for detection of preceding vehicles, pedestrians, obstacles, traffic signals, traffic signs, lanes, and the like.

Note that Fig. 16 illustrates an example of imaging ranges of the imaging units 12101 to 12104. An imaging range 12111 denotes the imaging range of the imaging unit 12101 provided at the front nose, imaging ranges 12112 and 12113 denote the imaging ranges of the imaging units 12102 and 12103 provided at the side mirrors, respectively, and an imaging range 12114 denotes the imaging range of the imaging unit 12104 provided at the rear bumper or the back door. A bird's-eye view image of the vehicle 12100 seen from the above is obtained by image data captured by the imaging units 12101 to 12104 being superimposed, for example.

At least one of the imaging units 12101 to 12104 may have a function of acquiring distance information. For example, at least one of the imaging units 12101 to 12104 may be a stereo camera constituted by a plurality of imaging elements or may be an imaging element that has pixels for phase difference detection.

For example, the microcomputer 12051 can extract, particularly, a closest three-dimensional object on a path through which the vehicle 12100 is traveling, which is a three-dimensional object traveling at a predetermined speed (for example, 0 km/h or higher) in the substantially same direction as that of the vehicle 12100, as a preceding vehicle by acquiring a distance to each three-dimensional object in the imaging ranges 12111 to 12114 and a temporal change in the distance (a relative speed with respect to the vehicle 12100) on the basis of distance information obtained from the imaging units 12101 to 12104. Further, the microcomputer 12051 can set an inter-vehicle distance to be secured in advance before a preceding vehicle and can perform automatic brake control (also including following stop control) or automatic acceleration control (also including following start control). Thus, it is possible to perform cooperative control for the purpose of, for example, automated driving in which the vehicle travels in an automated manner without requiring the driver to perform operations.

For example, the microcomputer 12051 can classify and extract three-dimensional data regarding three-dimensional objects into two-wheeled vehicles, normal vehicles, large vehicles, pedestrians, and other three-dimensional objects such as electric poles on the basis of distance information obtained from the imaging units 12101 to 12104 and can use the three-dimensional data to perform automated avoidance of obstacles. For example, the microcomputer 12051 categorizes surrounding obstacles of the vehicle 12100 into obstacles which can be viewed by a driver of the vehicle 12100 and obstacles which are difficult to be viewed. Then, the microcomputer 12051 determines a collision risk indicating a degree of risk of collision against each obstacle, and when the collision risk is equal to or higher than a set value and there is a likelihood of collision, an alarm is output to the driver through the audio speaker 12061 or the display unit 12062, forced deceleration or avoidance steering is performed through the drive system control unit 12010, and it is thus possible to perform driving support for collision avoidance.

At least one of the imaging units 12101 to 12104 may be an infrared camera that detects infrared rays. For example, the microcomputer 12051 can recognize a pedestrian by determining whether there is a pedestrian in the captured image of the imaging units 12101 to 12104. Such pedestrian recognition is performed by, for example, a procedure in which feature points in captured images of the imaging units 12101 to 12104 as infrared cameras are extracted and a procedure in which pattern matching processing is performed on a series of feature points indicating an outline of an object to determine whether or not the object is a pedestrian. When the microcomputer 12051 determines that there is a pedestrian in the captured images of the imaging units 12101 to 12104 and the pedestrian is recognized, the audio/image output unit 12052 controls the display unit 12062 so that a square contour line for emphasis is displayed in a superimposed manner on the recognized pedestrian. In addition, the audio/image output unit 12052 may control the display unit 12062 so that an icon indicating a pedestrian or the like is displayed at a desired position.

In the present specification, the system represents the entire device configured of a plurality of devices.

Note that the effects described in the present specification are merely examples, effects are not limited thereto, and other effects may be obtained.

Note that embodiments of the present technique are not limited to the above-described embodiments and various modifications can be made within the scope of the present technology without departing from the gist of the present technique.

Note that the present technology can also be configured as follows.
(1) An imaging element including:
   photoelectric conversion regions;
   a recessed portion region that has a plurality of recessed portions provided on a light-receiving surface side of the photoelectric conversion regions,
   in which
   the recessed portions are provided in a shape with no intersecting parts in a plan view.
(2) The imaging element according to (1) above,
   in which the recessed portions are configured of first recessed portions formed into a linear shape in a first direction and second recessed portions formed into a linear shape in a second direction, and
   the first recessed portions and the second recessed portions are provided in a shape with no intersecting parts.
(3) The imaging element according to (2) above, in which the shape including the first recessed portions and the second recessed portions is a quadrangular shape, and the first recessed portions and the second recessed portions are not provided at parts corresponding to vertexes of the quadrangular shape.
(4) The imaging element according to claim (2) above, in which the first recessed portions are provided between the second recessed portions.
(5) The imaging element according to claim (2) above, in which the first recessed portions with different lengths are provided.
(6) The imaging element according to (1) above, in which the recessed portions have a dot shape in a plan view.
(7) The imaging element according to (1) above, in which the recessed portions have a circular shape in a plan view.
(8) The imaging element according to (1) above, in which line widths of the recessed portions are uniform.
(9) The imaging element according to any one of (1) to (8) above, in which variations in depths of the recessed portions fall less than 10%.
(10) The imaging element according to any one of (1) to (9) above, further including: trenches between the adjacent photoelectric conversion regions,
   In which the recessed portions are provided in a shape that is not in contact with the trenches.
(11) The imaging element according to (10) above,
   in which the trenches include metal films.
(12) The imaging element according to any one of (2) to (11) above, further including: third recessed portions,
   in which the first recessed portions and the second recessed portions have a quadrangular shape in a sectional view, and
   the third recessed portions have a triangular shape in a sectional view.
(13) The imaging element according to (12) above,
   in which the third recessed portions have a quadrangular shape in a plan view, and
   each of the first to third recessed portions is provided in a shape that does not allow them to come into contact each other.
(14) The imaging element according to (12) or (13) above,
   in which depths of the first recessed portions and the second recessed portions are the same, and
   the depth of the third recessed portions is shallower than the depths of the first recessed portions and the second recessed portions.
(15) The imaging device according to any one of (12) to (14) above,
   in which the first recessed portions and the second recessed portions are formed by dry etching, and
   the third recessed portions are formed by wet etching.
(16) An electronic device including:
   an imaging element including photoelectric conversion regions, and
   a recessed portion region that has a plurality of recessed portions provided on a light-receiving surface side of the photoelectric conversion regions,
   the recessed portions being provided in a shape with no intersecting parts in a plan view;
      and
   a processing unit that processes a signal from the imaging element.

### [Reference Signs List]

1 Imaging device
2 Pixel
3 Pixel array unit
4 Vertical drive circuit
5 Column signal processing circuit
6 Horizontal drive circuit
7 Output circuit
8 Control circuit
9 Vertical signal line
10 Pixel drive wiring
11 Horizontal signal line
12 Semiconductor substrate
13 Input/output terminal
41 Semiconductor region
42 N-type semiconductor region
46 Transparent insulating film
48 Recessed portion
49 Light shielding film
51 On-chip lens
54 Inter-pixel separating portion
55 Insulator
61 Anti-reflection film
62 Hafnium oxide film
63 Aluminum oxide film
64 Silicon oxide film
101 Metal film

## Claims

1. An imaging element comprising:
photoelectric conversion regions; and
a recessed portion region that has a plurality of recessed portions provided on a light-receiving surface side of the photoelectric conversion regions,
wherein
the recessed portions are provided in a shape with no intersecting parts in a plan view.

2. The imaging element according to claim 1,
wherein the recessed portions are configured of first recessed portions formed into a linear shape in a first direction and second recessed portions formed into a linear shape in a second direction in a plan view, and
the first recessed portions and the second recessed portions are provided in a shape with no intersecting parts.

3. The imaging element according to claim 2, wherein the shape including the first recessed portions and the second recessed portions is a quadrangular shape, and the first recessed portions and the second recessed portions are not provided at parts corresponding to vertexes of the quadrangular shape.

4. The imaging element according to claim 2, wherein the first recessed portions are provided between the second recessed portions.

5. The imaging element according to claim 2, wherein the first recessed portions with different lengths are provided.

6. The imaging element according to claim 1, wherein the recessed portions have a dot shape in a plan view.

7. The imaging element according to claim 1, wherein the recessed portions have a circular shape in a plan view.

8. The imaging element according to claim 1, wherein line widths of the recessed portions are uniform.

9. The imaging element according to claim 1, wherein variations in depths of the recessed portions fall less than 10%.

10. The imaging element according to claim 1, further comprising:
trenches between the adjacent photoelectric conversion regions,
wherein the recessed portions are provided in a shape that is not in contact with the trenches.

11. The imaging element according to claim 10, wherein the trenches include metal films.

12. The imaging element according to claim 2, further comprising:
third recessed portions,
wherein the first recessed portions and the second recessed portions have a quadrangular shape in a sectional view, and
the third recessed portions have a triangular shape in a sectional view.

13. The imaging element according to claim 12,
wherein the third recessed portions have a quadrangular shape in a plan view, and
each of the first to third recessed portions is provided in a shape that does not allow them to come into contact each other.

14. The imaging element according to claim 12,
wherein depths of the first recessed portions and the second recessed portions are the same, and
the depth of the third recessed portions is shallower than the depths of the first recessed portions and the second recessed portions.

15. The imaging element according to claim 12,
wherein the first recessed portions and the second recessed portions are formed by dry etching, and
the third recessed portions are formed by wet etching.

16. An electronic device comprising:
an imaging element that includes photoelectric conversion regions, and
a recessed portion region that has a plurality of recessed portions provided on a light-receiving surface side of the photoelectric conversion regions,
the recessed portions being provided in a shape with no intersecting parts in a plan view;
and
a processing unit that processes a signal from the imaging element.
